# EUROPÄISCHE PATENTSCHRIFT

(11) **EP 3 164 525 B1**
(45) Veröffentlichungstag und Bekanntmachung des Hinweises auf die Patenterteilung: **06.11.2019**
(21) Anmeldenummer: 15736214.6
(22) Anmeldetag: 25.06.2015
(51) Int. Cl.: C23C 16/458, C30B 25/12, C30B 25/08

(54) **BESCHICHTETES FLACHES BAUTEIL IN EINEM CVD-REAKTOR**
COATED FLAT COMPONENT IN A CVD REACTOR
COMPOSANT PLAT REVÊTU DANS UN RÉACTEUR CVD

(30) Priorität: 03.07.2014 DE 102014109327
(43) Veröffentlichungstag der Anmeldung: 10.05.2017
(73) Patentinhaber: Aixtron SE, 52134 Herzogenrath (DE)
(72) Erfinder: KOLLBERG, Marcel, 52146 Würselen (DE); BRIEN, Daniel, 52064 Aachen (DE)
(74) Vertreter: Grundmann, Dirk
(86) Internationale Anmeldenummer: PCT/EP2015/064363
(87) Internationale Veröffentlichungsnummer: WO 2016/001053

(56) Entgegenhaltungen:
- US-A- 5 837 058
- US-A1- 2011 215 071

## Beschreibung

Die Erfindung betrifft einen CVD-Reaktor mit einem flachen Bauteil bzw. ein flaches Bauteil. Das Bauteil weist zwei bevorzugt gleich gestaltete, parallel zueinander verlaufende und um eine Dicke voneinander beabstandete Breitenseiten auf, wobei eine äußere Randkante auf jeder Breitseite, die an einen Rand einer äußeren Umfangsseite angrenzt, eine Kantenverrundung mit einem Kantenverrundungsradius und eine Kantenverrundungsbogenlänge aufweist, wobei die Dicke wesentlich kleiner ist, als ein zur Breitseitenfläche oberflächenäquivalenter Kreisdurchmesser, wobei das Bauteil einen Kernkörper ausbildet, dessen Werkstoff einen größeren Wärmeausdehnungskoeffizienten aufweist als der Werkstoff einer Beschichtung, mit der die Breitseiten und die Umfangsseite bei einer Beschichtungstemperatur, die größer ist als die Raumtemperatur, beschichtet ist, so dass bei Raumtemperatur die Beschichtung eine Druckspannung aufweist

Die WO 2013/064613 beschreibt einen CVD-Reaktor mit einem Gaseinlassorgan und einem darin angeordneten Suszeptor, der eine Kreisscheibenform aufweist und Träger von Substraten bei einem Beschichtungsprozess ist.

Die WO 99/43874 beschreibt ebenfalls einen CVD-Reaktor mit zwei scheibenförmigen Bauteilen, nämlich einer Prozesskammerdecke und einem Suszeptor zur Aufnahme der in der Prozesskammer zu beschichtenden Substrate.

Die US 2005/0183669 A1 beschreibt in der Figur 5 eine Kappe, die von einem flachzylindrischen Bauteil ausgebildet ist. Die Kappe besitzt eine Beschichtung und zwei voneinander wegweisende Breitseiten. Eine Breitseite geht unter Ausbildung einer Kantenverrundung mit einer Verrundungsbogenlänge von 90° in eine Umfangsfläche über. Die Umfangsfläche geht unter Ausbildung eines Wulstes und einer Knickstelle in die zweite Breitseite über.

Die US 5,837,058 beschreibt einen Suszeptor für eine CVD-Einrichtung, bei der ein am Rand verlaufender Wulst unter Ausbildung einer Verrundung in eine Umfangsfläche übergeht.

Die US 2003/0205324 A1 beziehungsweise US 2005/0092439 A1 beschreibt in der Figur 4 einen Suszeptor mit zwei voneinander wegweisenden Breitseiten, die jeweils unter Ausbildung einer Kantenverrundung in eine Umfangsfläche übergehen. Die Umfangsfläche besitzt eine sich in Umfangsrichtung erstreckende Kerbe.

Suszeptoren bzw. Deckenplatten in einem CVD-Reaktor werden in der Regel aus Graphit gefertigt. Die Graphitbauteile haben eine flache, scheibenförmige Gestalt. Sie haben zwei in der Regel gleich gestaltete, parallel zueinander verlaufende Breitseiten. Es kann sich um einen zylindrischen Körper handeln. Die Dicke des Körpers ist vergleichen mit seinem Durchmesser gering. Neben Bauteilen, die einen kreisförmigen Grundriss aufweisen, werden in einem CVD-Reaktor aber auch beschichtete flache Bauteile verwendet, die eine andere Grundfläche als eine kreisförmige Grundfläche aufweisen. Auch hier ist die Dicke gegenüber einem Durchmesser verhältnismäßig klein, wobei hier als Durchmesser der Durchmesser eines Kreises verstanden wird, der die selbe Grundfläche wie die Breitseite des Bauteiles aufweist. Der Graphitkörper ist mit einer wenige Mikrometer dicken Schicht beschichtet. Die Schichtdicke der Beschichtung ist geringer als 1 mm. Zur Beschichtung wird üblicherweise SiC oder TaC oder andere Carbide oder Hartstoffe verwendet. Das Aufbringen der Beschichtung findet bei Temperaturen von mehr als 1000°C statt. Der Kernkörper besitzt einen größeren Wärmeausdehnungskoeffizienten als die Beschichtung, mit der die Breitseite und die Umfangsseite beschichtet ist. Beim Abkühlen des beschichteten Bauteils von der Beschichtungstemperatur herunter zur Raumtemperatur treten Spannungen innerhalb der Beschichtung auf. Es handelt sich dabei um Druckspannungen. Die Druckspannungen sind eine Folge der unterschiedlichen Schrumpfung von Schicht und Kernkörper. Die Schrumpfung findet in Richtung zum Schwerpunkt des Bauteils statt. Handelt es sich um einen homogenen Körper, so ist dies der Massenschwerpunkt. Ansonsten ist es der Volumenschwerpunkt. Aufgrund der Scheibenform des Bauteils sind die Umfangsseiten verhältnismäßig weit vom Schwerpunkt entfernt, so dass dort die größten Spannungen in der Schicht bzw. im Bereich der Grenzfläche zwischen Beschichtung und Kernkörper auftreten. Innerhalb der Beschichtung, die beim Abkühlen um ein geringeres Maß schrumpft als der Kernkörper, bildet sich eine Druckspannung aus. Hohe Druckspannungen können langfristig die Qualität der Beschichtung beeinflussen.

Der Erfindung liegt daher die Aufgabe zugrunde, Maßnahmen zu ergreifen, um die Beschichtung robuster zu machen, insbesondere die in der Beschichtung auftretenden, kritischen maximalen Spannungen zu jedem Zeitpunkt (bei jeder Temperatur) zu reduzieren.

Gelöst wird die Aufgabe durch die in den Ansprüchen angegebene Erfindung.

Modellrechnungen haben ergeben, dass große Kantenverrundungsradien zu großen Maximalspannungen im Bereich der Grenzfläche zwischen Beschichtung und Kernkörper führen. Dies ist eine Folge der geometrisch bedingten Stabilität des durch die Kantenverrundung gebildeten Bogens der Beschichtung. Der Bogen besitzt eine relativ große Stabilität in Radialrichtung. Überraschend hat sich ergeben, dass eine Kantenverrundung mit einer Bogenlänge von mehr als 90° zu einer nennenswerten Verringerung der Maximalspannung führt. Eine nennenswerte Verringerung der Maximalspannung tritt auch dann ein, wenn der Kantenverrundungsradius etwa 1 mm beträgt bzw. geringer ist als 1 mm. Bei einer bevorzugten Ausgestaltung eines flachen Bauteils, bei dem die Breitseiten gleich gestaltet sind, das Bauteil somit gewissermaßen ein Flachzylinder ist, ist es von Vorteil, wenn sich an die Verrundung auf der Umfangs seite ein hinterschnittenes umlaufendes Tal anschließt. Dieses Tal kann in einen umlaufenden Berg übergehen. Letzterer kann wieder in ein Tal übergehen. Die Querschnittskonturlinie der Umfangsseite verläuft somit bevorzugt wellenförmig zwischen den beiden Breitseiten. Da die Bauteile im heißen Zustand beschichtet werden, treten die größten Spannungen im abgekühlten Zustand, also bei Raumtemperatur, auf. Die Spannungen vermindern sich beim Betrieb, währenddessen das Bauteil auf Temperaturen bis über 1000°C aufgeheizt wird. Es findet somit bei jedem Temperaturwechsel, also bei jeder Benutzung des Bauteils ein Lastwechsel statt. Mit den erfindungsgemäßen Vorgaben lassen sich die negativen Einflüsse des oftmaligen Lastwechsels auf die Standzeit des Bauteils vermindern. Es ist von Vorteil, wenn die Bogenlänge der Kantenverrundung mehr als 90°, bevorzugt mehr als 95°, 100°, 105°, 110°, 115 oder mehr als 120° beträgt. Die Querschnittskonturlinie der Umfangsseite hat keine Knickstellen, sondern besitzt eine Wellenform. Die Breitseite des Bauteils kann glatt gestaltet sein. Die Breitseite des Bauteils kann aber auch eine Vielzahl von Vertiefungen besitzen, jeweils zur Aufnahme eines kreisscheibenförmigen Wavers oder eines Substratträgers. Auch die nach unten weisende Breitseite des Bauteils, bei dem es sich um einen Suszeptor handelt, kann eine Strukturierung aufweisen. Selbiges gilt auch für eine Deckenplatte. Ferner kann vorgesehen sein, dass das Bauteil ein Loch besitzt. Es kann sich um zentrales Loch eines kreiszylindrischen Bauteils handeln. Die Innenwandung der Öffnung bildet ebenfalls eine Umfangsseite des Bauteils aus, die wie oben bereits beschrieben strukturiert ist. Sie besitzt verrundete Kanten, wobei der Rundungsradius kleiner als oder gleich 1 mm ist. Die Breitseitenfläche geht knickstellenfrei über die Kantenverrundung in die Umfangsseite über, wobei sich bei der Betrachtung einer Querschnittsfläche einer der Breitseitenfläche entsprechenden Gerade knickfrei eine durchgehend gekrümmte Bogenlinie anschließt. Die Breitseitenfläche geht gewissermaßen glatt in eine Bogenlinie über, die sich ohne Wechsel der Krümmungsrichtung um mehr als 90° krümmt bevor sie in einem Krümmungswendepunkt in einen entgegengerichtet gekrümmten Abschnitt übergeht, der entweder in einen geradlinig verlaufenden Abschnitt der Umfangsseite übergeht oder sich wellenförmig fortsetzt. In einer Querschnittsebene durch das Bauteil verlaufen die Ränder der Breitseite des Bauteils entlang zweier paralleler Linien. Die beiden parallelen Linien entsprechen den Breitseitenflächen und sind um weniger als die Hälfte, bevorzugt um weniger als ein Viertel ihrer Länge voneinander beabstandet. An ihren Enden gehen diese Linien in Bogenlinien über, die den Kantenverrundungen zugeordnet sind. Diese Bogenlinien verlaufen bevorzugt auf Kreisbögen oder kreisähnlichen Bögen. Die Umfangslänge dieser Bögen ist größer als 90°, bevorzugt mindestens 95° oder mindestens 100°. Ein erstes Ende eines Bogens schließt sich knickstellenfrei an jeweils eine der parallelen Linien an. Das zweite Ende des Bogens geht bevorzugt in einen entgegengerichtet gekrümmten Bogenabschnitt über, so dass sich auf der Umfangsfläche zumindest ein Tal ausbildet, dessen Grund gegenüber einer gedachten Linie durch die Scheitel zweiter Bögen zurückspringt. Bevorzugt besitzt das Bauteil auf seinem gesamten Umfang den zuvor beschriebenen Querschnitt des Randbereichs. Wegen der mehr als 90° betragenden Bogenlänge der Verrundung entsteht ein umlaufendes, zumindestens im Randbereichquerschnitt gerundetes Tal zwischen den beiden verrundeten Randkanten der Breitseitenflächen des Bauteils. Die Dicke des Bauteils ist bevorzugt um mindestens einen Faktor 5, bevorzugt einen Faktor 10 geringer als der oberflächenäquivalente Kreisdurchmesser. Das Bauteil kann einen kreiszylindrischen Grundriss aufweisen. Es kann aber auch einen von der Kreisform abweichenden Grundriss aufweisen. Die Erfindung betrifft die Ausgestaltung des Umfangsrandes eines beschichteten Bauteils eines CVD-Reaktors, wobei es sich bei dem Bauteil um einen Suszeptor, einen in einer Tasche einliegenden Substrathalter eines Suszeptors, einer Deckenplatte einer Prozesskammer oder um die Gasaustrittsplatte eines Showerheads handeln kann.

Ausführungsbeispiele werden nachfolgend anhand beigefügter Zeichnungen erläutert. Es zeigen:
- Figur 1: schematisch einen CVD-Reaktor mit darin angeordneten flachen Bauteilen 11, 12,
- Figur 2: ein erstes flaches Bauteil 12 in Form eines Kreiszylinders,
- Figur 3: den Schnitt gemäß der Linie 3 - 3 in Figur 2,
- Figur 4: eine Darstellung gemäß Figur 3 eines zweiten Ausführungsbeispiels,
- Figur 5: eine vergrößerte Darstellung gemäß Ausschnitt V in Figur 4,
- Figur 6: eine Darstellung gemäß Figur 5 eines dritten Ausführungsbeispiels,
- Figur 7: eine Darstellung gemäß Figur 5 eines vierten Ausführungsbeispiels,
- Figur 8: ein fünftes Ausführungsbeispiel in Form einer Kreisscheibe 11 mit einem zentralen Loch 8,
- Figur 9: den Schnitt gemäß der Linie IX-IX in Figur 8,
- Figur 10: eine Darstellung ähnlich der Figur 1, schematisch einen CVD-Reaktor mit einem Gaseinlassorgan 13, welches eine beschichtete Gasauslassplatte 15 mit Gasaustrittsöffnungen 16 aufweist,
- Figur 11: den Ausschnitt XI in Figur 10,
- Figur 12: einen beschichteten Suszeptor 12 mit Taschen, in denen beschichtete Substratträger 17 angeordnet sind,
- Figur 13: vergrößert den Ausschnitt XIII in Figur 12,
- Figur 14: vergrößert den Ausschnitt XIV in Figur 12 und
- Figur 15: ein weiteres Querschnittsprofil ähnlich der Figuren 11, 13, 14.

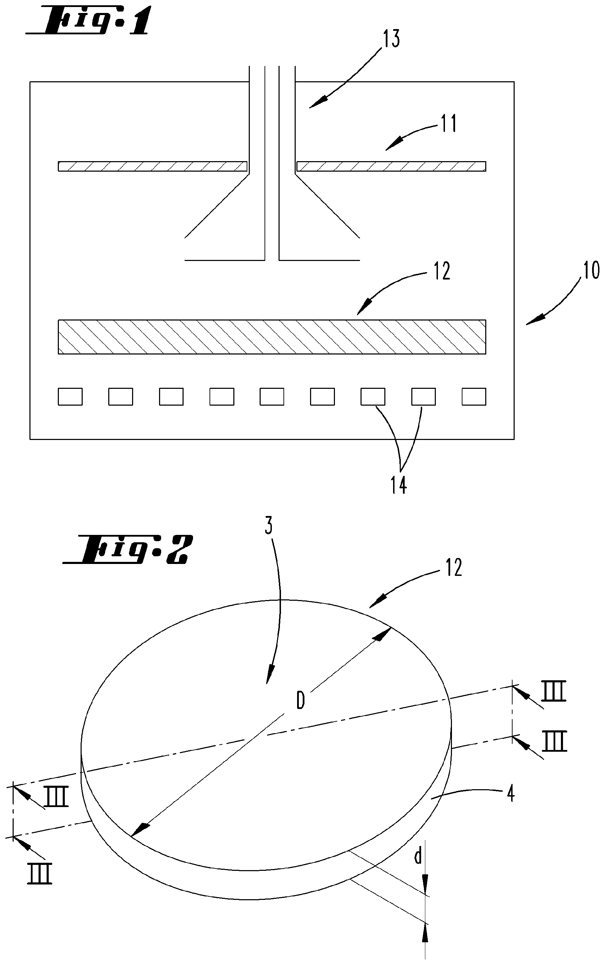

Die Figur 1 zeigt schematisch einen CVD-Reaktor. Der CVD-Reaktor 10 besitzt ein Gehäuse, in dem ein Gaseinlassorgan 13 angeordnet ist, mit dem Prozessgase in eine Prozesskammer des CVD-Reaktors 10 eingespeist werden können. Eine Prozesskammerdecke 11 wird von einem Graphitteil ausgebildet, welches in der Mitte ein Loch aufweist. Das Graphitteil besitzt eine kreisscheibenförmige Umrisskontur.

Unterhalb der Decke 11 der Prozesskammer befindet sich ein Boden der Prozesskammer, der von einem Suszeptor 12 ausgebildet wird, der von unten mittels einer Heizung 14 auf eine Prozesstemperatur von mehr als 1000°C aufheizbar ist. Der Suszeptor wird von einem Graphitteil 12 ausgebildet, welches einen kreisförmigen Umriss aufweist. Die Oberseite des Suszeptors 12 ist mit Strukturen versehen, die Taschen ausbilden zur Aufnahme von Substraten.

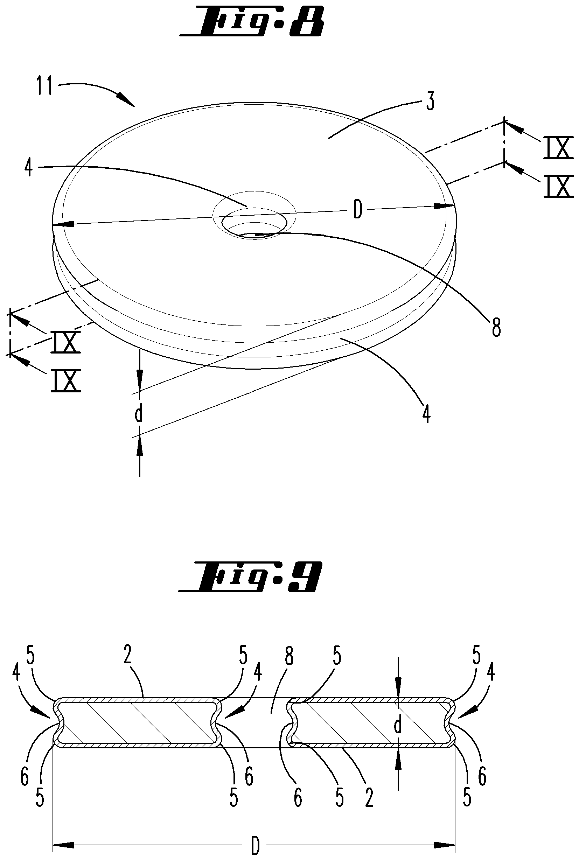

Die beiden Graphitbauteile 11, 12 besitzen hinsichtlich ihrer Umrisskontur gleichgestaltete Oberseiten und Unterseiten. Die Bauteile sind schematisch in den Figuren 2 bzw. 8 dargestellt, wobei die Kantenverrundungsradien zur Verdeutlichung wesentlich größer dargestellt sind, als sie es erfindungsgemäß sein sollen.

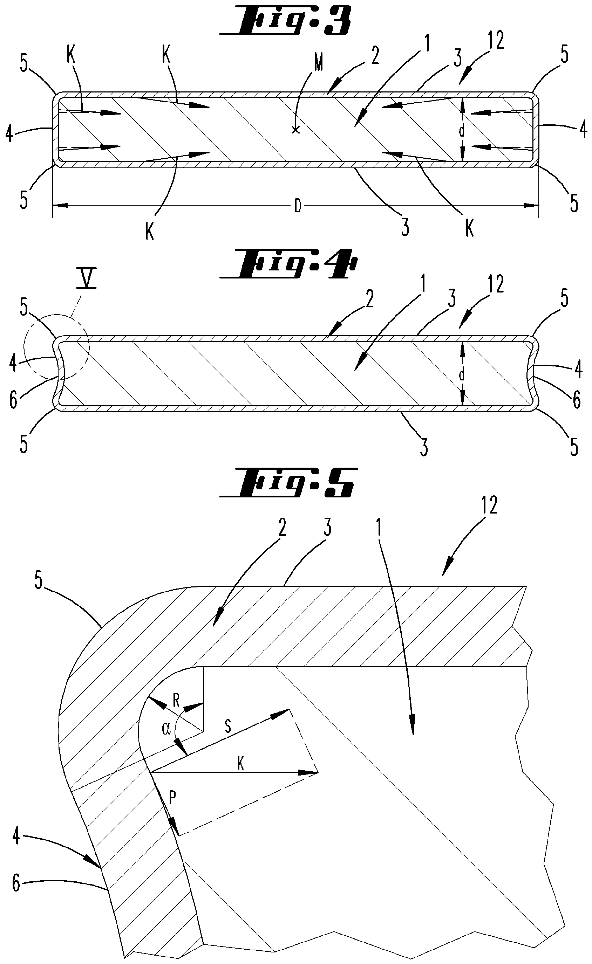

Das in der Figur 2 dargestellte Bauteil repräsentiert einen Suszeptor 12. Es handelt sich um einen kreisscheibenförmigen Graphitkörper 1 mit einer Dicke d von 1 - 4 cm und einem Durchmesser D von mehr als 20 cm, insbesondere von mehr als 30 cm. Die gesamte Außenoberfläche des aus Graphit bestehenden Kernkörpers 1 ist mit einer Beschichtung 2 versehen. Es handelt sich dabei um eine 50 bis 200 µm bzw. 75 - 150 µm dicke Beschichtung aus SiC bzw. TaC. Die Beschichtung wird bei einer Temperatur von mehr als 1000°C auf den Kernkörper 1 aufgebracht. Da Siliciumcarbid bzw. Tantalcarbid eine geringere thermische Ausdehnung besitzen als Graphit, schrumpft der Graphitkernkörper 1 um ein stärkeres Maß entlang der in der Figur 3 eingezeichneten und mit K markierten Linie in Richtung auf den Schwerpunkt M als die Beschichtung 2. Dies hat ein leichtes Schüsseln der beiden voneinander weg weisenden, vom Umriss her gleich gestalteten Breitseiten 3 zur Folge. Auch in den Umfangsseiten 4 ist eine leichte Einschnürung beim Erkalten des beschichteten Bauteils 12 zu beobachten.

Erfindungsgemäß sind die Randkanten 5 des Bauteils 12 mit einer geringfügigen Verrundung versehen. Der Rundungsradius R ist größer als die Dicke der Beschichtung, aber maximal 1 mm.

Bei dem in den Figuren 4 und 5 dargestellten Ausführungsbeispiel besitzt die Randkante 5 eine Verrundung mit einem Rundungsradius R von 1 mm. Die Bogenlänge α der Kantenverrundung 5 ist hier größer als 90°. Die Kantenverrundungsbogenlänge α hat hier einen Wert von etwa 120°. Dies hat zur Folge, dass die vertikal an der Umfangsseite 4 angreifende, auf die Schrumpfung zurückzuführende Kraft K nicht vertikal an der Oberfläche angreift, sondern in einem Winkel dazu. Die Kraft K spaltet sich somit in senkrecht zueinander stehende Teilkräfte P und S auf. Die senkrecht zur Grenzfläche zwischen Kernkörper 1 und Beschichtung 2 wirkende Kraftkomponente S, hat einen Betrag, der geringer ist als der Betrag der Kraft K. Dies führt zu einer Verminderung der Druckkräfte innerhalb der Beschichtung bzw. an der Grenzfläche zwischen Beschichtung 2 und Kernkörper 1.

In dem Bereich der Kantenverrundungen 5 baut sich innerhalb der gerundeten Beschichtung 2 eine Druckspannung auf, die nicht vertikal über die Grenzfläche zwischen Beschichtung 2 und Kernkörper 1 in den Kernkörper 1 abgeleitet werden kann. Aufgrund der geometrischen Stabilität des Bogens werden die Kräfte vielmehr tangential in die Beschichtungsabschnitte der Breitseite 3 bzw. der Umfangsseite 4 eingeleitet. Eine Reduzierung des Verrundungsradius R auf Werte unterhalb 1 mm führt zu einer signifikanten Verminderung dieser Spannungen.

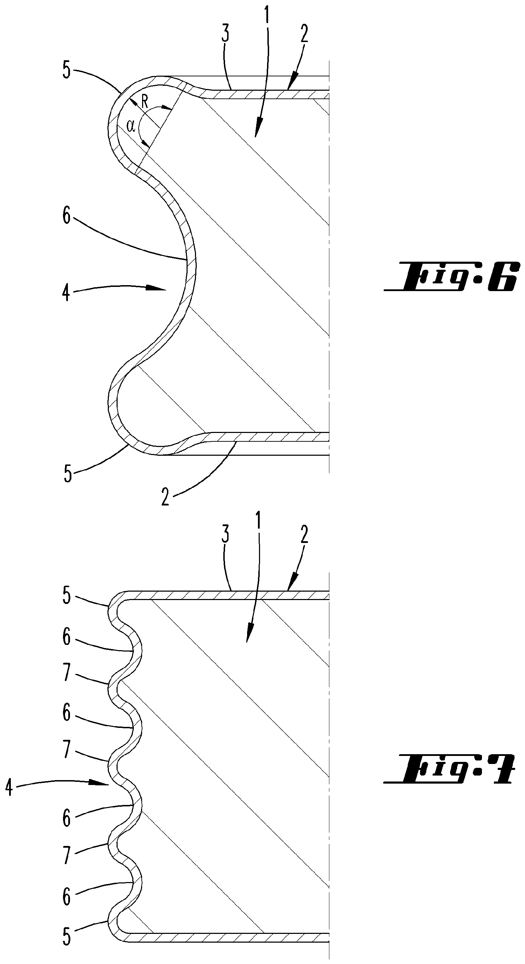

Das in der Figur 6 dargestellte Ausführungsbeispiel zeigt ein Bauteil mit einem aus Graphit bestehenden Kernteil 1, welches mit einer Siliciumcarbidbeschichtung versehen ist. Die Randkanten 5 sind mit einer Verrundung um nahezu 180° versehen. Die Verrundung erstreckt sich bis über die Ebene der Breitseite 3. Zwischen den beiden Kantenverrundungen 5, mit denen die Umfangsseite 4 in die jeweilige Breitseite 3 übergeht, bildet sich ein Tal 6.

Bei dem in der Figur 7 dargestellten Ausführungsbeispiel verläuft die Querschnittskonturlinie der Umfangsseite 4 wellenförmig, so dass sich Berge 7 und Täler 6 abwechseln. Zwischen den beiden Randkanten 5 verläuft die Umfangsseite 4 knickstellenfrei. Konvexe Rundungsabschnitte gehen glattwandig in konkave Rundungsabschnitte über. Es bilden sich somit in Umfangsrichtung um das Bauteil verlaufende Täler 6 und zwischen Tälern 6 liegenden Bergen 7.

Die Figur 8 zeigt ein weiteres Ausführungsbeispiel. Hier ist das Bauteil 11 eine Deckenplatte. die im Zentrum ein Loch 8 besitzt. Das Loch 8 bildet eine Umfangsseite 4 aus, die über eine verrundete Randkante 5 in die Breitseite 3 übergeht. Auch hier bildet sich zwischen zwei Kantenverrundungen 5 ein Tal 6 aus.

Der Erfindung liegt die Erkenntnis zugrunde, dass Verrundungen unter Ausbildung von Einschnürungen in die Umfangsseite 4 bzw. die Breitenseitenfläche 2 übergehen sollten bzw. nicht größer als ein Minimalwert sein dürfen. Dies führt zu einer Spannungskompensation. Des Weiteren ist es von Vorteil, wenn die einzelnen Flächenabschnitte 3, 4, 5, 6, 7 knickstellenfrei, also glatt unter Ausbildung von Verrundungszonen mit geringen Rundungsradien ineinander übergehen.

Im Ausführungsbeispiel werden Graphitkörper beschrieben, die eine Kreiszylinderform besitzen. Die Erfindung betrifft aber auch solche flachen Graphitkörper, die eine von der Kreisform abweichende Breitseitenumrisskontur aufweisen. Auch hier sollte der Radius des Übergansbereichs zwischen der Breitseitenfläche und der Umfangsfläche kleiner als 1 mm sein und der Radiusabschnitt mehr als 90° betragen.

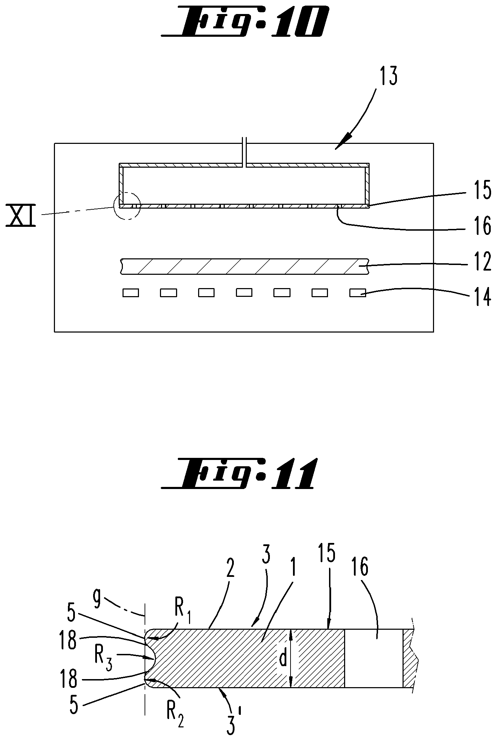

Die Figur 10 zeigt schematisch ein weiteres Ausführungsbeispiel einer Prozesskammer eines CVD-Reaktors mit einem Gaseinlassorgan 13, welches als Showerhead ausgebildet ist. Es besitzt eine aus Graphit bestehende Gasaustrittsplatte 15, die Gasaustrittsöffnungen 16 aufweist. Die Außenumfangsfläche der Gasaustrittsplatte 15 besitzt eine Querschnittskontur, wie sie die Figur 11 zeigt. Zumindest im Randabschnitt der beiden sich gegenüberliegenden Breitseiten 3, 3' verlaufen die Breitseiten 3, 3' parallel zueinander. Die Breitseitenfläche geht dort jeweils knickstellenfrei in eine Kantenverrundung 5 über, die einen Verrundungsradius R₁, R₂ besitzt, der etwa 1 mm beträgt. An einer Übergangsstelle 18 etwa nach einer Bogenlänge der Kantenverrundung 5 von 120° schließt sich knickstellenfrei ein Bogenabschnitt mit einem Radius R₃ an. Bezogen auf eine Mittelebene, die zwischen den beiden Breitseiten 3, 3' verläuft, ist der Querschnitt des Randes der Gasaustrittsplatte 15 symmetrisch. Dies bedeutet, dass die Radien R₁, R₂ gleich groß sind. An die Kantenverrundung 5 mit dem Radius R₂ schließt sich an einer Übergangsstelle 18 der Bogen mit dem Radius R₃ an. Eine gedachte Gerade g, die durch die Scheitelpunkte der Kantenverrundungen 5 gelegt ist, überspannt ein Tal 6, dessen Boden vom Radius R₃ gebildet ist.

Die in Figur 10 dargestellte Prozesskammer besitzt einen Suszeptor 12, der von unten mittels einer Heizeinrichtung 14 beheizbar ist. Die Umfangsseite 4 des Suszeptors 12 kann eine Kontur aufweisen, wie sie in den Querschnittsdarstellungen der Figuren 11, 13, 14 und 15 gezeigt ist.

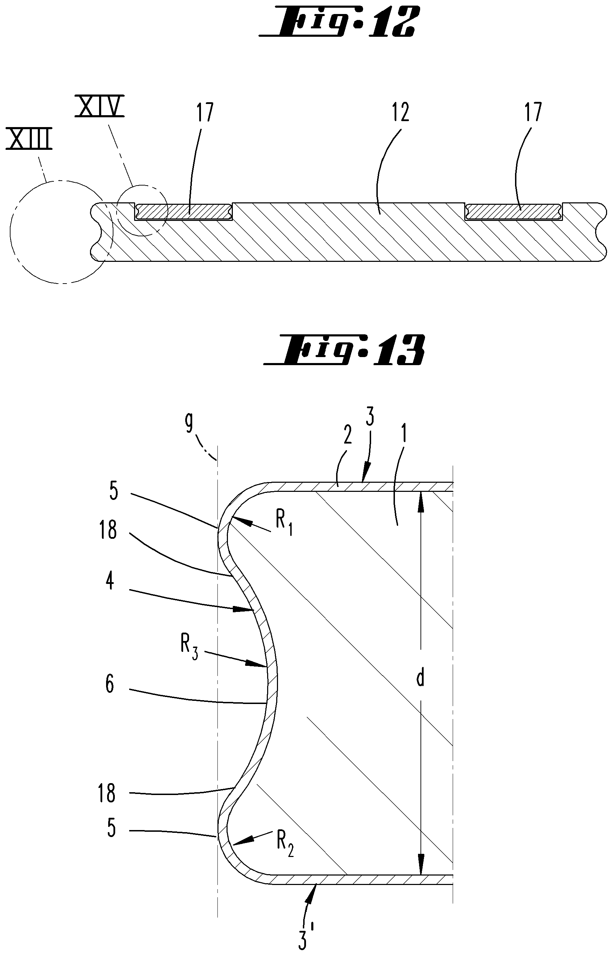

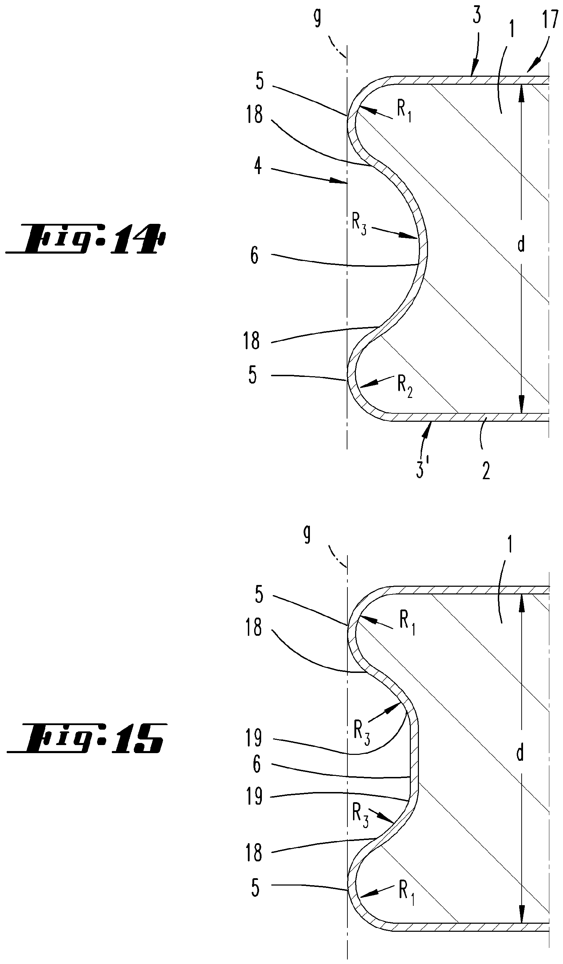

Die Figur 12 zeigt ein weiteres Ausführungsbeispiel eines Suszeptors, bei dem in Taschen des Suszeptors 12 Substratträger 17 einliegen. Die Substratträger 17 werden im Beschichtungsbetrieb durch einen Gasstrom drehangetrieben und sind auf einem vom Gasstrom erzeugten Gaslager gelagert. Die Figur 13 zeigt den Randquerschnitt des Suszeptors 12 und die Figur 14 zeigt den Randquerschnitt des Substratträgers 17. Aus den Figuren 13 und 14 geht hervor, dass der Querschnitt der Umfangsseite 4 aus einer Hintereinander-Anordnung dreier Bögen zusammengesetzt ist, welche Bögen mit den Radien R₁, R₂, R₃ an Übergangsstellen 18 knickstellenfrei ineinander übergehen. Die Radien R1, R2 betragen etwa 1 mm. Der Radius R₃ hängt von der Dicke d des Kernes 1 ab, der mit einer maximal 0,5 mm dicken Beschichtung 2 beschichtet ist und kann wesentlich größer sein als die Radien R₁ und R₂. Der Radius R₃ kann bei einer Dicke des Bauteils von 13 cm zwischen 8 und 9 mm liegen. Der Querschnittradius des Tals 6 zwischen den beiden Kantenverrundungen 5 kann somit bevorzugt mindestens fünfmal größer sein, als der Kantenverrundungsradius. Der Radius R₃ ist ferner so gewählt, dass eine Übergangsstelle 18 entsteht, in der lediglich die Krümmungsrichtung wechselt, ansonsten die Konturlinien aber knickstellenfrei ineinander übergehen.

Das in der Figur 15 dargestellte Ausführungsbeispiel zeigt eine Variante, bei der sich jeweils an die Kantenverrundungen 5 entgegengerichtet gekrümmte Bögen mit Radien R3 anschließen, die in ein auf einer Geraden verlaufendes Tal 6 übergehen, wobei das ebene Tal 6 an Übergangsstellen 19 knickstellenfrei in die hohle Verrundung mit dem Radius R₃ übergeht.

**Bezugszeichenliste:**

| | | | |
|---|---|---|---|
| 1 | Kernkörper | α | Bogenlänge |
| 2 | Beschichtung | d | Dicke |
| 3, 3' | Breitseite | g | Gerade |
| 4 | Umfangsseite | | |
| 5 | Randkante, Kantenverrundung | | |
| 6 | Tal | D | Kreisdurchmesser |
| 7 | Berg | K | Kraft |
| 8 | Loch | P | Teilkräfte |
| 10 | CVD-Reaktor | R1 | Radius |
| 11 | Deckenplatte | R2 | Radius |
| 12 | Suszeptor | R3 | Radius |
| 13 | Gaseinlassorgan | S | Teilkräfte |
| 14 | Heizeinrichtung | M | Schwerpunkt |
| 15 | Gasaustrittsplatte | | |
| 16 | Gasaustrittsöffnung | | |
| 17 | Substratträger | | |
| 18 | Übergangsstelle | | |
| 19 | Übergangsstelle | | |

## Patentansprüche

1. CVD-Reaktor mit einem flachen Bauteil (11, 12), welches Bauteil (11, 12, 15, 17) zwei parallel zueinander verlaufende und um eine Dicke (d) voneinander beabstandete Breitseiten (3, 3') aufweist, wobei ein äußerer Rand (5) jeder Breitseite (3, 3') unter Ausbildung einer Kantenverrundung mit einem Kantenverrundungsradius (R) und einer Kantenverrundungsbogenlänge (α) knickfrei in einen Rand einer äußeren Umfangsseite (4) übergeht, wobei die Dicke (d) wesentlich kleiner ist, als ein zur Breitseitenfläche oberflächenäquivalenter Kreisdurchmesser (D), wobei das Bauteil (11, 12, 15, 17) einen Kernkörper (1) ausbildet, dessen Werkstoff einen größeren Wärmeausdehnungskoeffizienten aufweist als der Werkstoff einer Beschichtung (2), mit der die Breitseiten (3, 3') und die Umfangsseite (4) bei einer Beschichtungstemperatur, die größer ist als die Raumtemperatur, beschichtet ist, so dass bei Raumtemperatur die Beschichtung eine Druckspannung aufweist, **dadurch gekennzeichnet, dass** zur Reduzierung der Spannung zwischen der Beschichtung (2) und dem Kernkörper (1) die Kantenverrundungsbogenlänge (α) größer als 90° ist.

2. Flaches Bauteil zur Verwendung in einem CVD-Reaktor, welches Bauteil zwei parallel zueinander verlaufende und um eine Dicke (d) voneinander beabstandete Breitseiten (3, 3') aufweist, wobei ein äußerer Rand (5) jeder Breitseite (3, 3') unter Ausbildung einer Kantenverrundung mit einem Kantenverrundungsradius (R) und einer Kantenverrundungsbogenlänge (α) knickfrei in einen Rand einer äußeren Umfangsseite (4) übergeht, wobei die Dicke (d) wesentlich kleiner ist, als ein zur Breitseitenfläche oberflächenäquivalenter Kreisdurchmesser (D), wobei das Bauteil (11, 12, 15, 17) einen Kernkörper (1) ausbildet, dessen Werkstoff einen größeren Wärmeausdehnungskoeffizienten aufweist als der Werkstoff einer Beschichtung (2), mit der die Breitseiten (3, 3') und die Umfangsseite (4) bei einer Beschichtungstemperatur, die größer ist als die Raumtemperatur, beschichtet ist, so dass bei Raumtemperatur die Beschichtung eine Druckspannung aufweist, **dadurch gekennzeichnet, dass** zur Reduzierung der Spannung zwischen der Beschichtung (2) und dem Kernkörper (1) die Kantenverrundungsbogenlänge (α) größer als 90° ist.

3. CVD-Reaktor nach Anspruch 1 oder Bauteil nach Anspruch 2, **dadurch gekennzeichnet, dass** die Beschichtung SiC, TaC oder ein anderer Hartstoff ist.

4. CVD-Reaktor oder Bauteil nach einem der vorhergehenden Ansprüche, **dadurch gekennzeichnet, dass** der Kantenverrundungsradius (R) maximal 1 mm beträgt und/oder größer ist, als die Dicke der Beschichtung (2).

5. CVD-Reaktor oder Bauteil nach einem der vorhergehenden Ansprüche, **dadurch gekennzeichnet, dass** der Kernkörper (1) aus Graphit besteht.

6. CVD-Reaktor oder Bauteil nach einem der vorhergehenden Ansprüche, **dadurch gekennzeichnet, dass** die Beschichtung (2) bei einer Temperatur von > 1000°C aufgebracht worden ist.

7. CVD-Reaktor oder Bauteil nach einem der vorhergehenden Ansprüche, **dadurch gekennzeichnet, dass** die Umfangsseite (4) knickstellenfrei ineinander übergehende, zumindest ein Tal (6) ausbildende Rundungsabschnitte aufweist.

8. CVD-Reaktor oder Bauteil nach Anspruch 7, **dadurch gekennzeichnet, dass** die Umfangsseite (4) im Querschnitt ausschließlich von Kreisbogenabschnitten gebildet ist.

9. CVD-Reaktor oder Bauteil nach einem der vorhergehenden Ansprüche, **dadurch gekennzeichnet, dass** das Bauteil (11, 12) ein Suszeptor (12) oder eine Deckenplatte (11), ein Substratträger (17) oder eine Gasaustrittsplatte (15) eines Gaseinlassorgans (13) ist.

10. CVD-Reaktor oder Bauteil nach einem der vorhergehenden Ansprüche, **dadurch gekennzeichnet, dass** das Bauteil (11, 12) eine kreiszylindrische Gestalt aufweist und insbesondere einen Durchmesser (D) aufweist von mindestens 20 cm, insbesondere mindestens 30 cm und einer Dicke (d) zwischen 1 und 3 cm.

11. CVD-Reaktor oder Bauteil nach einem der Ansprüche 1 bis 9, **dadurch gekennzeichnet, dass** das Bauteil (11, 12) einen von der Kreisform abweichenden Grundriss aufweist.

12. CVD-Reaktor oder Bauteil nach einem der vorhergehenden Ansprüche, **dadurch gekennzeichnet, dass** in einer Querschnittsebene durch das Bauteil (11, 12, 15, 17) der Querschnitt des Bauteils zumindest nahe des Randes des Bauteils zwei parallel zueinander verlaufende Linien aufweist, die den Randbereichen der Breitseiten (3, 3') des Bauteils (11, 12, 15, 17) entsprechen und die Enden dieser Linien knickstellenfrei in Bogenlinien übergehen, die den Kantenverrundungen (5) entsprechen, wobei die Bogenlinien auf einem Kreisbogen oder einem kreisähnlichen Bogen verlaufen und eine gekrümmte Verbindungslinie die Bogenlinien knickstellenfrei miteinander verbindet und zumindest ein Tal (6) ausbildet, welches gegenüber einer durch die Scheitel der Bogenlinien gezogenen Geraden zurückspringt.

13. CVD-Reaktor oder Bauteil nach einem der vorhergehenden Ansprüche, **dadurch gekennzeichnet, dass** die Umfangsseite (4) im Querschnitt ausschließlich von hintereinander angeordneten Kreisbogenlinien mit Radien (R1, R2, R3) gebildet ist.

## Claims

1. A CVD reactor with a flat component (11, 12), wherein the component (11, 12, 15, 17) exhibits two broad sides (3, 3') that run parallel to each other and are spaced apart from each other by a thickness (d), wherein an outer edge (5) of each broad side (3, 3') transitions without any kinks into an edge of an outer peripheral side (4), forming an edge rounding with an edge rounding radius (R) and an edge rounding arc length (α), wherein the thickness (d) is substantially less than a circle diameter (D) that is surface-equivalent to the broad side surface, wherein the component (11, 12, 15, 17) forms a core body (1) whose material exhibits a greater coefficient of thermal expansion than the material of a coating (2) with which the broad sides (3, 3') and peripheral side (4) are coated at a coating temperature greater than the room temperature, so that the coating exhibits a compressive stress at room temperature, **characterized in that** the edge rounding arc length (α) is greater than 90° to reduce the stress between the coating (2) and core body (1).

2. A flat component for use in a CVD reactor, wherein the component exhibits two broad sides (3, 3') that run parallel to each other and are spaced apart from each other by a thickness (d), wherein an outer edge (5) of each broad side (3, 3') transitions without any kinks into an edge of an outer peripheral side (4), forming an edge rounding with an edge rounding radius (R) and an edge rounding arc length (α), wherein the thickness (d) is substantially less than a circle diameter (D) that is surface-equivalent to the broad side surface, wherein the component (11, 12, 15, 17) forms a core body (1) whose material exhibits a greater coefficient of thermal expansion than the material of a coating (2) with which the broad sides (3, 3') and peripheral side (4) are coated at a coating temperature greater than the room temperature, so that the coating exhibits a compressive stress at room temperature, **characterized in that** the edge rounding arc length (α) is greater than 90° to reduce the stress between the coating (2) and core body (1).

3. The CVD reactor according to claim 1 or component according to claim 2, **characterized in that** the coating is SiC, TaC or another hard material.

4. The CVD reactor or component according to one of the preceding claims, **characterized in that** the edge rounding radius (R) measures at most 1 mm and/or exceeds the thickness of the coating (2).

5. The CVD reactor or component according to one of the preceding claims, **characterized in that** the core body (1) consists of graphite.

6. The CVD reactor or component according to one of the preceding claims, **characterized in that** the coating (2) was applied at a temperature of >1000°C.

7. The CVD reactor or component according to one of the preceding claims, **characterized in that** the peripheral side (4) exhibits rounding sections that transition into each other without any kinks and form at least one valley (6).

8. The CVD reactor or component according to claim 7, **characterized in that** the peripheral side (4) is formed exclusively by circular arc sections in cross section.

9. The CVD reactor or component according to one of the preceding claims, **characterized in that** the component (11, 12) is a susceptor (12) or a cover plate (11), a substrate carrier (17) or a gas outlet plate (15) of a gas inlet member (13).

10. The CVD reactor or component according to one of the preceding claims, **characterized in that** the component (11, 12) exhibits a circle cylindrical shape, and in particular exhibits a diameter (D) of at least 20 cm, in particular at least 30 cm, and a thickness (d) of between 1 and 3 cm.

11. The CVD reactor or component according to one of claims 1 to 9, **characterized in that** the component (11, 12) exhibits an outline that deviates from the circular shape.

12. The CVD reactor or component according to one of the preceding claims, **characterized in that**, in a cross sectional plane through the component (11, 12, 15, 17), the cross section of the component exhibits two lines running parallel to each other at least near the edge of the component, which correspond to the edge regions of the broad sides (3, 3') of the component (11, 12, 15, 17), and the ends of these lines transition without any kinks into arc lines, which correspond to edge roundings (5), wherein the arc lines run on a circular arc or near-circular arc, and a curved connecting line joins the arc lines with each other without any kinks, and forms at least one valley (6), which jumps back relative to a straight line drawn through the vertices of the arc lines.

13. The CVD reactor or component according to one of the preceding claims, **characterized in that** the peripheral side (4) is formed in cross section exclusively by circular arc lines with radii (R1, R2, R3) that are arranged one behind the other.

## Revendications

1. Réacteur CVD, comprenant un composant plat (11, 12), lequel composant (11, 12, 15, 17) présente deux faces larges (3, 3') s'étendant parallèlement l'une à l'autre et espacées d'une épaisseur (d), dans lequel un bord extérieur (5) de chaque face large (3, 3') évolue sans pli en un bord d'un flanc périphérique externe (4) en formant un arrondi de bords ayant un rayon d'arrondi de bords (R) et une longueur d'arc d'arrondi de bords (α), dans lequel l'épaisseur (d) est sensiblement inférieure à un diamètre de cercle (D) équivalent à la superficie de face large, dans lequel le composant (11, 12, 15, 17) forme un corps formant noyau (1) dont le matériau présente un coefficient de dilatation thermique plus élevé que le matériau d'un revêtement (2) dont les faces larges (3, 3') et le flanc périphérique (4) sont revêtus à une température de revêtement qui est supérieure à la température ambiante de manière que le revêtement présente, à température ambiante, une contrainte de compression, **caractérisé en ce que** pour réduire la contrainte/tension entre le revêtement (2) et le corps formant noyau (1), la longueur d'arc d'arrondi de bords (α) est supérieure à 90°.

2. Composant plat destiné à être utilisé dans un réacteur CVD, lequel composant comprend deux faces larges s'étendant parallèlement l'une à l'autre (3, 3') et espacées d'une épaisseur (d), dans lequel un bord extérieur (5) de chaque face large (3, 3') évolue sans pli en un bord d'un flanc périphérique externe (4) en formant un arrondi de bords ayant un rayon d'arrondi de bords (R) et une longueur d'arc d'arrondi de bords (α), dans lequel l'épaisseur (d) est sensiblement inférieure à un diamètre de cercle (D) équivalent à la superficie de face large, dans lequel le composant (11, 12, 15, 17) forme un corps formant noyau (1) dont le matériau présente un coefficient de dilatation thermique plus élevé que le matériau d'un revêtement (2) dont les faces larges (3, 3') et la face périphérique (4) sont revêtues à une température de revêtement qui est supérieure à la température ambiante de manière que le revêtement présente, à température ambiante, une contrainte de compression, **caractérisé en ce que** pour réduire la contrainte/tension entre le revêtement (2) et le corps formant noyau (1), la longueur d'arc d'arrondi de bords (α) est supérieure à 90°.

3. Réacteur CVD selon la revendication 1 ou composant selon la revendication 2, **caractérisé en ce que** le revêtement est du SiC, TaC ou un autre matériau dur.

4. Réacteur CVD ou composant selon l'une des revendications précédentes, **caractérisé en ce que** le rayon d'arrondi de bords (R) est au maximum de 1 mm et/ou est supérieur à l'épaisseur du revêtement (2).

5. Réacteur CVD ou composant selon l'une des revendications précédentes, **caractérisé en ce que** le corps formant noyau (1) est fait de graphite.

6. Réacteur CVD ou composant selon l'une des revendications précédentes, **caractérisé en ce que** le revêtement (2) a été appliqué à une température > 1000°C.

7. Réacteur CVD ou composant selon l'une des revendications précédentes, **caractérisé en ce que** le flanc périphérique (4) présente des tronçons arrondis se fondant ensembles sans pli et qui forment au moins une vallée (6).

8. Réacteur CVD ou composant selon la revendication 7, **caractérisé en ce que** le flanc périphérique (4) est formé, en section transversale, exclusivement par des tronçons en arc de cercle.

9. Réacteur CVD ou composant selon l'une des revendications précédentes, **caractérisé en ce que** le composant (11, 12) est un suscepteur (12) ou une plaque formant plafond (11), un support de substrat (17) ou une plaque de sortie de gaz (15) d'un organe d'entrée de gaz (13).

10. Réacteur CVD ou composant selon l'une des revendications précédentes, **caractérisé en ce que** le composant (11, 12) a une forme cylindrique circulaire et en particulier un diamètre (D) d'au moins 20 cm, en particulier d'au moins 30 cm, et une épaisseur (d) entre 1 et 3 cm.

11. Réacteur CVD ou composant selon l'une des revendications 1 à 9, **caractérisé en ce que** le composant (11, 12) présente un plan de base s'écartant de la forme circulaire.

12. Réacteur CVD ou composant selon l'une des revendications précédentes, **caractérisé en ce que**, dans un plan transversal passant par le composant (11, 12, 15, 17), la section transversale du composant présente, au moins près du bord du composant, deux lignes s'étendant parallèlement entre elles qui correspondent aux zones de bord des faces larges (3, 3') du composant (11, 12, 15, 17) et les extrémités de ces lignes évoluent sans plis en des lignes courbes qui correspondent aux arrondis de bords (5), dans lequel les lignes courbes s'étendent en arc de cercle ou similairement à un arc de cercle et une ligne de liaison courbée relie les lignes courbes entre elles sans plis et forme au moins une vallée (6) qui s'étend en retrait par rapport à une ligne droite passant par les sommets des lignes courbes.

13. Réacteur CVD ou composant selon l'une des revendications précédentes, **caractérisé en ce que** le flanc périphérique (4) est formé en section transversale exclusivement par des lignes en arc de cercle ayant des rayons et qui sont agencées de manière consécutive.
